# EUROPEAN PATENT APPLICATION

(11) **EP 4 345 806 A1**
(43) Date of publication of application: **03.04.2024**
(21) Application number: 22819301.7
(22) Date of filing: 13.05.2022
(51) Int. Cl.: G09G 3/3208, G09G 3/32, H01L 27/32

(54) **DISPLAY PANEL AND DISPLAY APPARATUS**

(30) Priority: 07.06.2021 CN 202110633783
(71) Applicant: GUANGDONG OPPO MOBILE TELECOMMUNICATIONS CORP., LTD., Dongguan, Guangdong 523860 (CN)
(72) Inventor: LIU, Changyu, Dongguan, Guangdong 523860 (CN)
(74) Representative: Novagraaf Technologies
(86) International application number: PCT/CN2022/092730
(87) International publication number: WO 2022/257703

(57) **Abstract**

A display panel (10), comprising: a plurality of pixel units (100), each pixel unit (100) comprising a plurality of light-emitting devices (110); a plurality of driving wires; and a plurality of driving circuits (210), the plurality of driving circuits (210) being respectively connected to the plurality of light-emitting devices (110) in one-to-one correspondence by means of the plurality of driving wires, and each driving circuit (210) being used for outputting a driving signal to an anode of a connected light-emitting device (110). The length of the driving wire of each light-emitting device (110) in a same pixel unit (100) is negatively correlated with the on-state duration of the light-emitting device (110), and the driving wire is connected between an output end of the driving circuit (210) and the anode of the light-emitting device (110).

## Description

### CROSS-REFERENCE TO RELATED APPLICATIONS

The present application claims priority to Chinese Patent Application No. 202110633783.7, entitled "DISPLAY PANEL AND DISPLAY DEVICE", filed Jun. 7, 2021, which is herein incorporated by reference in its entirety.

### TECHNICAL FIELD

The present disclosure relates to the technical field of display, and in particular to a display panel and a display device.

### BACKGROUND

The statements herein merely provide background information pertinent to the present disclosure and do not necessarily constitute exemplary techniques.

With the continuous development of science and technology, electronic devices are emerging in endlessly, which brings great convenience to people's daily life and entertainment. At present, the electronic devices are constantly developing towards large screens. In order to increase the screen proportion of electronic devices and truly realize full screens, under-screen camera technology has received much attention.

The under-screen camera may divide a display screen of an electronic device into a main screen region and an auxiliary screen region. The auxiliary screen region is a region configured to accommodate the under-screen camera. A light emitting device in the auxiliary screen region is usually disposed in a visual region of the camera, a driving circuit of the light emitting device is disposed on a periphery of the auxiliary screen region, and the light emitting device is connected to the driving circuit through metal wires. However, different metal wires may generate different degrees of RC loading. Thus, the display color cast easily occurs in the auxiliary screen region, and the display effect of the electronic device is greatly reduced.

### SUMMARY OF THE DISCLOSURE

According to various embodiments of the present disclosure, a display panel and a display device are provided.

A display panel includes a plurality of pixel units, a plurality of driving wires, and a plurality of driving circuits.

Each of the pixel units includes a plurality of light emitting devices.

The driving circuits are connected to the light emitting devices through the driving wires in a one-to-one correspondence manner, and each of the driving circuits is configured to output a driving signal to an anode of a corresponding one of the light emitting devices.

A length of a corresponding driving wire of each of the light emitting devices in a same pixel unit is negatively correlated with an on-status duration of the corresponding one of the light emitting devices, and each of the driving wires is a wire connected between an output terminal of each of the driving circuits and the anode of the corresponding one of the light emitting devices.

A display device includes a photosensitive device and the above display panel, and the photosensitive device faces towards the transparent region of the display panel.

The details of one or more embodiments of the present disclosure are provided in the accompanying drawings and descriptions below. The other features, purposes, and advantages of the present disclosure will become apparent from the description, the accompanying drawings, and the claims.

### BRIEF DESCRIPTION OF THE DRAWINGS

In order to more clearly illustrate the technical solutions in some embodiments of the present disclosure or exemplary technologies, hereinafter, a brief introduction will be given to the accompanying drawings that are used in the description of some embodiments or the exemplary technologies. Obviously, the accompanying drawings in the description below are merely some embodiments of the present disclosure. For those of ordinary skill in the art, other accompanying drawings may be obtained based on these accompanying drawings without any creative efforts.
FIG. 1 is a partial structural schematic view of a display device in some embodiments of the present disclosure.
FIG. 2 is a structural schematic view of a display panel in some embodiments of the present disclosure.
FIG. 3 is a partially enlarged schematic view illustrating a light emitting device and a driving circuit in some embodiments of the present disclosure.
FIG. 4 is a cross-sectional structural schematic view of the driving circuit in some embodiments of the present disclosure.
FIG. 5 is a structural schematic view illustrating a transparent region, a first external sub-region, and a second external sub-region in some embodiments of the present disclosure.
FIG. 6 is a first structural schematic view illustrating the transparent region, a first external region, and a second external region in some embodiments of the present disclosure.
FIG. 7 is a second structural schematic view illustrating the transparent region, the first external region, and the second external region in some embodiments of the present disclosure.
FIG. 8 is a schematic view illustrating a pixel arrangement of the transparent region in some embodiments of the present disclosure.
FIG. 9 is a timing schematic view illustrating on-time of a plurality of light emitting devices that have different colors in some embodiments shown in FIG. 8.
FIG. 10 is a schematic view illustrating a driving wire mode in some embodiments of the present disclosure.
FIG. 11 is a schematic view illustrating another driving wire mode in some embodiments of the present disclosure.
FIG. 12 is a circuit view of a driving circuit in some embodiments of the present disclosure.

### Explanation of reference signs is as follows.

10 - display panel; 11 - transparent region; 11a - first pixel region; 11b - second pixel region; 12 - external region; 121- first external region; 122 - second external region; 12a - first external sub-region; 12b - second external sub-region; 12c - third external sub-region; 12d - fourth external sub-region; 100 - pixel unit; 110 - light emitting device; 110a - first light emitting device; 110b - second light emitting device; 110c - third light emitting device; 210 - driving circuit; 210a - first driving circuit; 210b - second driving circuit; 210c - third driving circuit; 2101 - gate electrode; 2102 - source electrode; 2103 - drain electrode; 2104 - source electrode contacting structure; 2105 - drain electrode contacting structure; 211 - anode reset unit; 212 - gate electrode reset unit; 213 - data writing unit; 214 - threshold compensation unit; 215 - light emitting control unit; 311 - substrate; 312 - buffer layer; 313 - gate insulating layer; 314 - interlayer insulating layer; 315 - planarization layer; 316 - pixel definition layer; 20 - photosensitive device.

### DETAILED DESCRIPTION

In order to facilitate the understanding of the embodiments of the present disclosure, a more comprehensive description of the embodiments of the present disclosure will be provided below with reference to accompanying drawings. The preferred embodiment of the present disclosure is shown in the accompanying drawings. However, the embodiments of the present disclosure may be implemented in many different forms, and are not limited to the embodiments described herein. On the contrary, the purpose of providing these embodiments is to make the disclosure of the embodiments of the present disclosure more thorough and comprehensive.

Unless otherwise defined, all technical and scientific terms used in the present disclosure have the same meanings as commonly understood by those skilled in the art belonging to the embodiments of the present disclosure. The terms used in the embodiments of the specification of the present disclosure are only for the purpose of describing the specific embodiments, and are not intended to limit the embodiments of the present disclosure. The term "and/or" used in the present disclosure includes any and all combinations of one or more related listed items.

In the description of the embodiments of the present disclosure, the directions or positional relationships indicated by the terms "up", "down", "vertical", "horizontal", "inside", "outside", etc. are based on the methods or positional relationships shown in the accompanying drawings. It is only intended to facilitate the description of the embodiments of the present disclosure and simplify the description, but does not indicate or imply that the device or the element referred to must have a specific orientation, be constructed and operated in a specific orientation. Therefore, it cannot be understood as a limitation on the embodiments of the present disclosure.

The terms "first", "second", or the like used in the present disclosure may be used to describe various components, but these components are not limited by these terms. These terms are only used to distinguish one component from another component. For example, without departing from the scope of the present disclosure, a first direction may be referred to as a second direction, and similarly, the second direction may be referred to as the first direction. Both the first direction and the second direction are directions, but not the same direction.

The terms "first" and "second" in the present disclosure are only configured to describe purposes and cannot be understood as indicating or implying relative importance or implicit indicating the quantity of technical features indicated. Therefore, features limited to "first" or "second" may explicitly or implicitly include at least one of these features. In the description of the present disclosure, "plurality" means at least two, e.g., two, three, etc., unless otherwise expressly and specifically defined. In the description of the present disclosure, and "plurality" means at least one, e.g., one, two, etc., unless otherwise expressly and specifically defined.

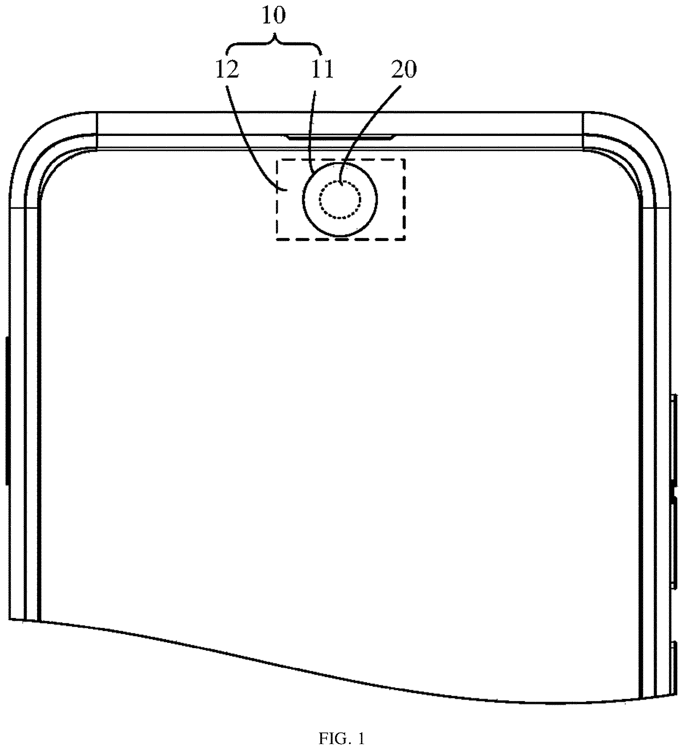

FIG. 1 is a partial structural schematic view of a display device in some embodiments of the present disclosure. The display device may be a smartphone, a tablet computer, a game device, an augmented reality (AR) device, a notebook computer, a desktop computing device, a wearable device, etc. For convenience of understanding, the display device being a mobile phone is taken as example for explanation. As illustrated in FIG. 1, in some embodiments, the display device includes a display panel 10 and a photosensitive device 20.

The display panel 10 includes a transparent region 11 and an external region 12 that are adjacent to each other. A shape of the transparent region 11 may be circular, rectangular, elliptical, polygonal, irregular special-shaped, etc., which is not limited in the present disclosure. A shape of the external region 12 may be annular, rectangular, or the like, which is not limited in the present disclosure. At least part of the photosensitive device 20 faces towards the transparent region 11. The photosensitive device 20 may be disposed under the transparent region 11. The photosensitive device 20 is configured to emit and/or receive optical signals through the transparent region 11 of the display panel 10. That is, the transparent region 11 is a region located above the photosensitive device 20. It should be noted that, the term "above" refers to a direction pointing from a back shell of the display device to a display screen, and the term "under" refers to a direction pointing from the display screen to the back shell.

The photosensitive device 20 is configured to perform a test and control based on optical parameters through receiving light rays. The photosensitive device 20 may be a camera. The photosensitive device 20 may also be an ambient light sensor, an optical distance sensor (such as, an infrared sensor, a laser sensor, a proximity sensor, a distance sensor, or an optical distance sensor), a structured light module, a time of flight (TOF) lens module, or an optical fingerprint sensor, etc.

In order to facilitate explanation, in each embodiment of the present disclosure, the photosensitive device 20 being the camera is taken as an example for explanation. The driving circuit is generally formed in a plurality of functional layers that are disposed in a stacked manner. The plurality of functional layers may reduce the incident light intensity of the camera and even cause a diffraction problem in imaging, thereby greatly affecting the imaging quality of the camera. Therefore, for an under-screen camera, by disposing the driving circuits of pixels of a display region corresponding to the camera are out of the display region, the imaging quality may be effectively improved, which improves the user experience.

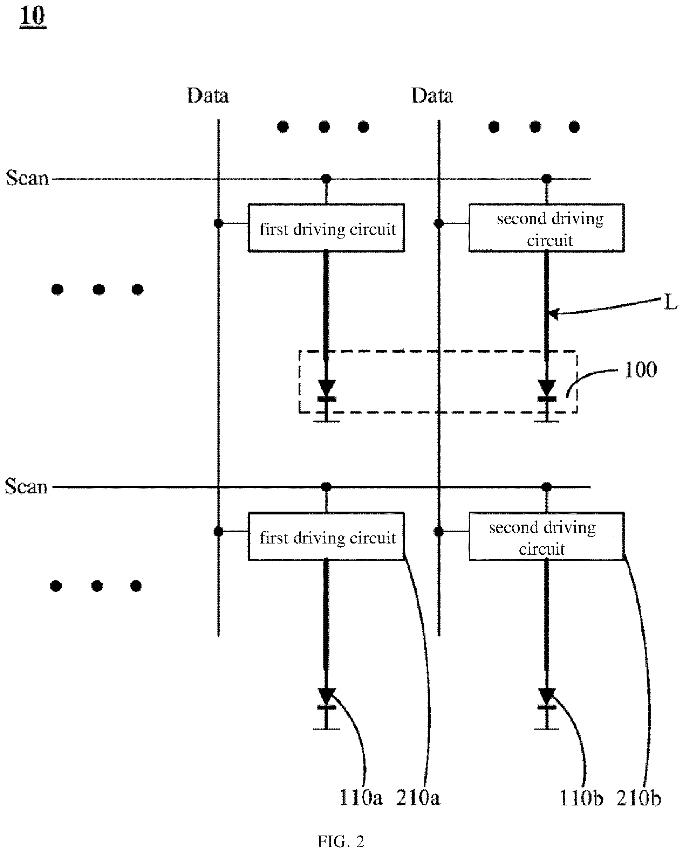

FIG. 2 is a structural schematic view of a display panel in some embodiments of the present disclosure. As illustrated in FIG. 2, in some embodiments, the display panel 10 includes a plurality of pixel units 100, a plurality of driving wires L and a plurality of driving circuits.

FIG. 2 shows two pixel units 100 in the display panel 10. Each pixel unit 100 includes a plurality of light emitting devices (i.e. diodes in the figure). The number of the light emitting devices that are included by each pixel unit 100 may be 2, 3, 4, etc., which may be determined by the display effect that needs to be implemented. In some embodiments, when the display panel 10 needs to realize richer colors or a larger color gamut, more light emitting devices 110 may be disposed. For example, each pixel unit 100 includes four light emitting devices with different colors. The above numbers are only used for exemplary illustration, but not used for limiting the protection scope of the present embodiment. In order to simplify the illustration, the pixel unit 100 of the present embodiment including two light emitting devices is taken as an example for illustration, the two light emitting devices are respectively named as a first light emitting device 110a and a second light emitting device 110b.

The plurality of driving circuits are respectively connected to a plurality of the light emitting devices in a one-to-one correspondence. Each driving circuit is configured to output driving signals to an anode of a corresponding light emitting device. Corresponding to the pixel unit 100 including two light emitting devices, the display panel 10 of the present embodiment includes two driving circuits. The two driving circuits are respectively named as a first driving circuit 210a and a second driving circuit 210b. The first driving circuit 210a is connected to an anode of the first light emitting device 110a, and the second driving circuit 210b is connected to an anode of the second light emitting device 110b, so as to respectively output the driving signals to the corresponding light emitting device. In order to facilitate explanation, in the embodiments of the present disclosure, a wire connected between an output terminal of the driving circuit and the anode of the light emitting device is defined as the driving wire.

In some embodiments, taking the first light emitting device 110a being a red light emitting device and the second light emitting device 110b being a green light emitting device as an example, the color cast in the related art is described. When two light emitting devices light up at the same moment, a color displayed by the pixel unit 100 is yellow. When the red light emitting device lights up earlier than the green light emitting device, before the green light emitting device lights up, the color displayed by the pixel unit 100 is red. When the green light emitting device lights up earlier than the red light emitting device, before the red light emitting device lights up, the color displayed by the pixel unit 100 is green. Thus, when on-status starting moments of the plurality of light emitting devices in the same pixel unit 100 are different, the color displayed by the pixel unit 100 is affected, which causes the color cast of the display panel 10. Thus, the plurality of light emitting devices in the same pixel unit 100 need to light up at the same moment, so as to jointly achieve the color and brightness required to be displayed by the pixel unit 100. When a difference between the on-status starting moments of any two light emitting devices in the same pixel unit 100 is less than a preset threshold, it may be understood that the two light emitting devices light up at the same moment. The preset threshold may be, for example, 0.01 microseconds (ms). The on-status starting moment refers to a moment when the light emitting device reaches a stable target brightness. A display driving chip determines the target brightness of each light emitting device according to an image that needs to be displayed.

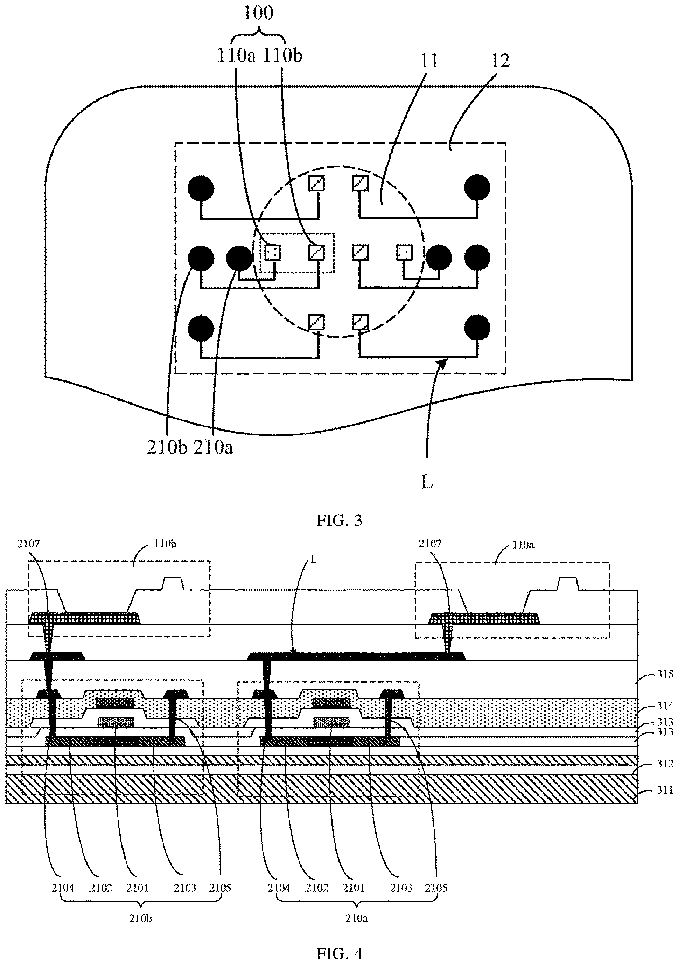

FIG. 3 is a partially enlarged schematic view of a light emitting device and a driving circuit in some embodiments of the present disclosure. As illustrated in FIG. 3, the first driving circuit 210a located in the external region 12 may be electrically connected to the first light emitting device 110a located in the transparent region 11 through the driving wire L. And accordingly, the second driving circuit 210b located in the external region 12 may also be electrically connected to the second light emitting device 110b located in the transparent region 11 through the driving wire L. As illustrated in FIG. 3, lengths of the driving wires are not exactly equal to each other. In some embodiment, a length of the driving wire of each light emitting device in the same pixel unit 100 is negatively correlated with an on-status duration of the light emitting device. That is, the longer the on-status duration of the light emitting device, the shorter the length of the driving wire of the light emitting device connected to the corresponding driving circuit. The driving wire L may be a transparent metal wire, such as, an indium tin oxide (ITO) metal wire, an aluminum zinc oxide (AZO) metal wire, etc. The shape and a position of the external region 12 of the present embodiment are only for exemplary illustration, but not for limiting the protection scope of the external region 12 of the present disclosure.

FIG. 4 is a cross-sectional structural schematic view of the driving circuit in some embodiments of the present disclosure, and a cross-sectional direction in FIG. 4 is perpendicular to a display surface of the display panel 10. As illustrated in FIG. 4, in some embodiments, a substrate may include multiple polyimide (PI) substrates 311 and multiple buffer layers 312 alternately disposed in sequence. In the embodiment shown in FIG. 4, the substrate includes two polyimide (PI) substrates 311 and two buffer layers 312 alternately disposed in sequence. The substrate may also include a greater number of polyimide (PI) substrates 311 and buffer layers 312. Two gate insulating layers 313 (GI1 layer and GI2 layer), an interlayer insulating layer 314, a planarization layer 315, and a pixel definition layer 316 are sequentially disposed on the substrate. The first driving circuit 210a and the second driving circuit 210b are further formed in the gate insulating layer 313, the interlayer insulating layer 314, and the planarization layer 315. In some embodiments, the first driving circuit 210a includes a gate electrode 2101, a source electrode 2102, a drain electrode 2103, a source electrode contacting structure 2104, and a corresponding drain electrode contacting structure 2105. An anode layer of the first light emitting device 110a is electrically connected to the source electrode 2102 through the driving wire L. The second driving circuit 210b may also include the gate electrode 2101, the source electrode 2102, the drain electrode 2103, the source electrode contacting structure 2104, and the drain electrode contacting structure 2105. An anode layer of the second light emitting device 110b is also electrically connected to the corresponding source electrode 2102 through the driving wire L.

As illustrated in FIG. 3 and FIG. 4, due to the different positions of the light emitting devices 110 in the transparent region 11, the positions of the driving circuits corresponding to the light emitting devices are also different, which causes the driving wires to have different lengths. Any one of the driving wires is coupled with another driving wire to produces an RC loading, which reduces a transmission speed of the driving signals on the driving wires. For some light emitting devices having a longer on-status duration, the RC loading may further delay the on-status starting moment of the light emitting device, which deteriorates the display color cast. Therefore, in some embodiments, by adjusting lengths of the driving wires of the respective light emitting devices, the transmission duration of the driving signals to the corresponding light emitting device may be accordingly changed. A total on-status duration from the driving circuit outputting the driving signals to on-time of the corresponding light emitting device is a sum of a transmission duration and an on-status duration. Thus, different on-status durations may be compensated based on different transmission durations, so that the total on-status durations of the light emitting devices in the same pixel unit are the same, thereby ensuring that the pixel unit may present accurate color and brightness. That is, the present embodiment provides a display panel with accurate color and better display effect.

Each light emitting device in some embodiments may be, but not limited to, an organic light emitting diode (OLED), a quantum dot light emitting diode (QLED), or a micro-scale light emitting diode (Micro LED), etc. In each embodiment of the present disclosure, the light emitting device being the organic light emitting diode is taken as an example. Each light emitting device may be the organic light emitting diode with different colors, such as red OLED, green OLED, or blue OLED, etc. The driving circuits of the light emitting devices may be the same, but materials of light emitting layers of the light emitting devices with different colors are different, so as to implement display with different colors, thereby making the display device implement full-color display.

In some embodiments, each pixel unit includes light emitting devices of at least two colors. The display panel 10 includes the transparent region 11, a first external sub-region 12a, and a second external sub-region 12b that are disposed along a first direction. The first direction is a direction from a center of the transparent region 11 to an outside of the transparent region 11. The transparent region, the first external sub-region, and the second external sub-region may display the image.

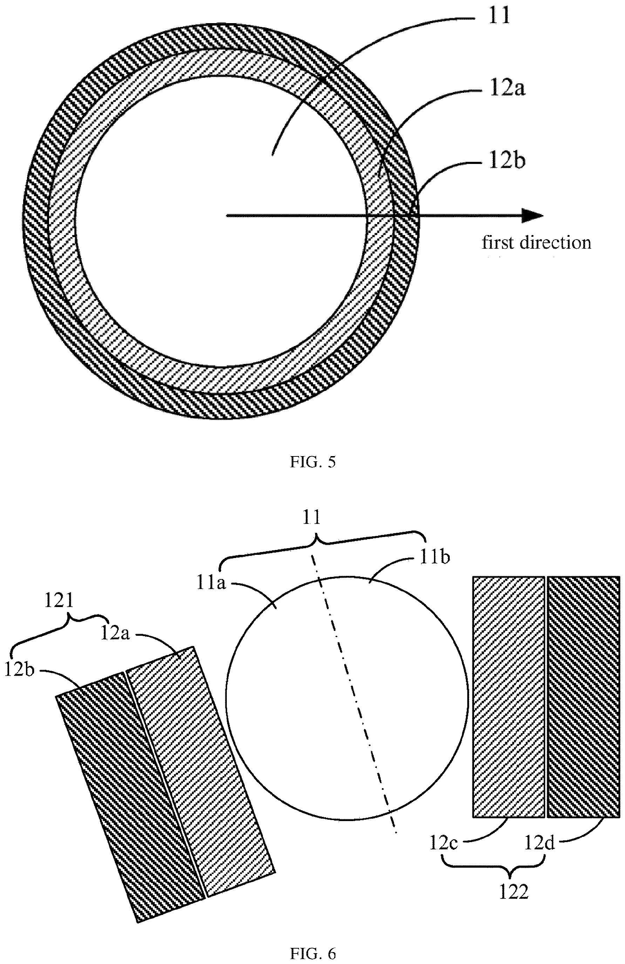

FIG. 5 is a structural schematic view illustrating a transparent region 11, a first external sub-region 12a, and a second external sub-region 12b in some embodiments of the present disclosure.

As illustrated in FIG. 5, in the present embodiment, the shape of the transparent region 11 is circular, and the center of the transparent region 11 is a center of a circle. A direction pointing from the center of the circle to the outside of the transparent region 11 along any radius may be the first direction. The first external sub-region 12a is an annular structure surrounding the transparent region 11. The second external sub-region 12b is an annular structure surrounding the first external sub-region 12a. In some embodiments, an outer contour of the second external sub-region 12b is relatively regular. Thus, the display panel 10 may be easily compatible with other structures in the display panel 10. Other structures in the display panel 10 may include, for example, display pixels of a main screen region. The display panel 10 also includes the main screen region besides the transparent region 11, the first external sub-region 12a, and the second external sub-region 12b. The main screen region is also a region that may be configured to display the image.

The transparent region 11 is provided with a plurality of the pixel units (not shown in figures). The light emitting device with the longest on-status duration in a plurality of colors of the same pixel unit is a target light emitting device. The driving circuit 210 corresponding to the target light emitting device is located in the first external sub-region 12a, and the driving circuits corresponding to the rest of the light emitting devices in the same pixel unit are located in the second external sub-region 12b. The on-status duration of the light emitting device is determined by a characteristic, such as a device color, a device structure, or a target brightness, etc.

In some embodiments, the pixel unit including a red light emitting device, a green light emitting device and a blue light emitting device is taken as an example. When it is necessary to display a white image of 255 grayscale, the red light emitting device, the green light emitting device, and the blue light emitting device need to be lighted up to 255 grayscale. The target brightness corresponding to the 255 grayscale of each light emitting device is not completely the same, to enable the white image to have a desired color coordinate or color temperature. Corresponding to the different target brightness, the on-status duration of the light emitting device of each color is also different. Thus, different lengths of the driving wires need to be set for the light emitting devices of different colors. In some embodiments, a distance between the first external sub-region 12a and the transparent region 11 is smaller, thus a driving circuit corresponding to the light emitting device having the longest on-status duration is disposed in the first external sub-region 12a, and the required length of the driving wire is correspondingly smaller. Thus, the RC loading of the target light emitting device may be effectively inhibited. The on-status durations of other light emitting devices except the target light emitting device are shorter, so that a longer driving signal wire may be disposed, to match with the total on-status duration of the target light emitting device. Furthermore, the light emitting devices of all colors in the pixel unit may be ensured to be simultaneously lighted up.

The colors of the target light emitting devices in different pixel units may be different. For example, according to different arrangements of the light emitting devices in different display panels, or according to different sizes of the light emitting devices in different pixel units, the target light emitting device may be any one or two of the green light emitting device, the red light emitting device, and the blue light emitting device, which may be determined by the pixel arrangement manner. In some embodiments, it is only necessary that the plurality of light emitting devices in the same pixel unit have the same total on-status duration. A relationship between the total on-status durations of different pixel units is not limited.

FIG. 6 is a first structural schematic view illustrating the transparent region 11, a first external region 121, and a second external region 122 in some embodiments of the present disclosure. As illustrated in FIG. 6, in some embodiments, the display panel 10 includes the transparent region 11, the first external region 121, and the second external region 122. The first external region 121 and the second external region 122 are respectively located at two opposite sides of the transparent region 11. The transparent region 11 includes a first pixel region 11a and a second pixel region 11b, the first external region 121 is close to the first pixel region 11a, and the second external region 122 is close to the second pixel region 11b. Each of the first pixel region 11a and the second pixel region 11b is provided with the plurality of the pixel units (not shown in figures). Each of the plurality of pixel units includes the light emitting devices of at least two colors. The plurality of the light emitting devices located in the first pixel region 11a are connected to the plurality of the driving circuits located in the first external region 121 in a one-to-one correspondence manner. The plurality of the light emitting devices located in the second pixel region 11b are connected to the plurality of the driving circuits located in the second external region 122 in a one-to-one correspondence manner. In the present embodiment, the light emitting devices in the transparent region 11 are respectively connected to one of the first external region 121 and the second external region 122, so that the lengths of the driving wires of different light emitting devices may be further balanced, and an area of a single external region may be reduced, thereby facilitating the arrangement of other signal wires.

As illustrated in FIG. 6, the first external region 121 includes a first external sub-region 12a close to the transparent region 11 and a second external sub-region 12b away from the transparent region 11. The second external region 122 includes a third external sub-region 12c close to the transparent region 11 and a fourth external sub-region 12d away from the transparent region 11. The light emitting device having the longest on-status duration in the plurality of light emitting devices of the same pixel unit is the target light emitting device. The driving circuit corresponding to the target light emitting device located in the first pixel region 11a is located in the first external sub-region 12a. In the first pixel region 11a, the driving circuits corresponding to the other light emitting devices located in the same pixel unit as the target light emitting device are located in the second external sub-region 12b. The driving circuit corresponding to the target light emitting device located in the second pixel region 11b is located in the third external sub-region 12c. In the second pixel region 11b, the driving circuits corresponding to the other light emitting devices located in the same pixel unit as the target light emitting device are located in the fourth external sub-region 12d. In the present embodiment, by disposing multiple external sub-regions with different distances from the center of the transparent region, the target light emitting devices in different pixel regions may be respectively connected to the corresponding external sub-regions, thereby improving the correspondence between the length of the driving wire and each light emitting device, and further improving the uniformity of the display chromaticity of the display panel.

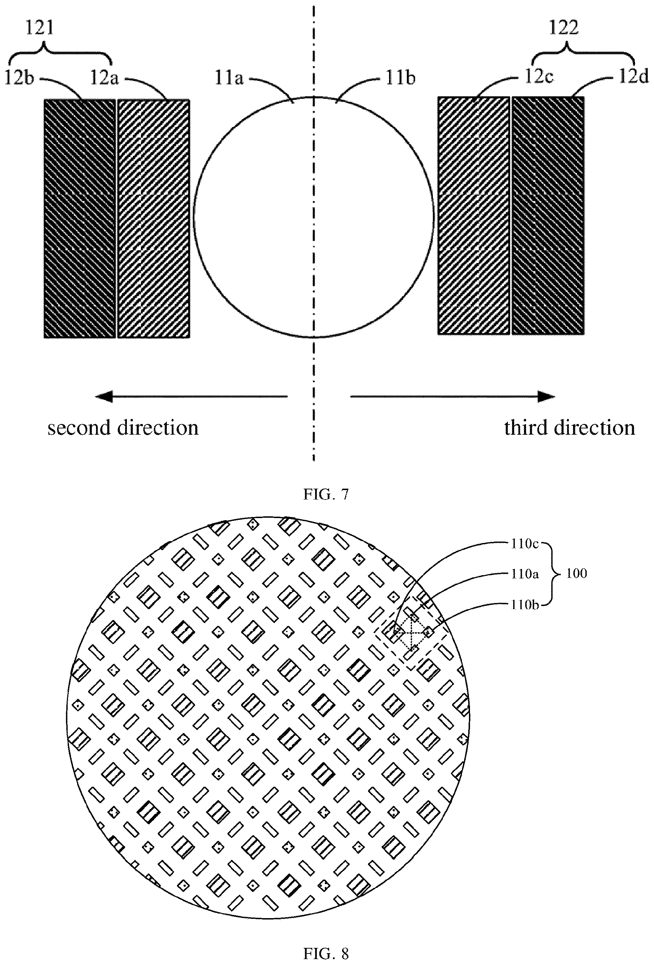

FIG. 7 is a second structural schematic view illustrating the transparent region 11, the first external region 121, and the second external region 122 in some embodiments of the present disclosure. As illustrated in FIG. 7, in some embodiments, the shape of the transparent region 11 is an axisymmetric figure. The light transmission region 11 is divided into the first pixel region 11a and the second pixel region 11b by a symmetry axis (i.e., dashed-dotted line in FIG. 7). The first pixel region 11a and the first external region 121 are sequentially disposed along a second direction. The second pixel region 11b and the second external region 122 are sequentially disposed along a third direction. The second direction and the third direction are disposed opposite to each other, and perpendicular to the symmetry axis. In some embodiments, two pixel regions of a symmetrical structure and two external regions of another symmetrical structure are provided, and symmetry axes of the two symmetrical structures coincide with each other, which greatly simplifies the design complexity of the driving wires, thereby reducing various signal transmission problems caused by the wiring design, and improving the reliability of the display panel. Further, the first external sub-region 12a and the third external sub-region 12c may be symmetrically disposed relative to the symmetry axis, and the second external sub-region 12b and the fourth external sub-region 12d may also be symmetrically disposed relative to the symmetry axis, so that the display uniformity may be improved.

Further, each of the external regions may be rectangular. By adopting rectangular external regions, the plurality of driving circuits may be arranged in an array in the external regions. Compared with the arrangement mode of the embodiment shown in FIG. 5, the design difficulty of the arrangement mode of the driving circuits and the driving wires in the embodiments is relatively low, and the driving circuits and the driving wires are easier to implement. In order to facilitate explanation, in the subsequent embodiments, implementation modes are further provided based on the structure of the embodiment as shown in FIG. 7.

FIG. 8 is a schematic view illustrating a pixel arrangement of the transparent region 11 in some embodiments of the present disclosure. As illustrated in FIG. 8, in some embodiments, each the pixel unit 100 includes two first light emitting devices 110a, one second light emitting device 110b, and one third light emitting device 110c. Each of the two first light emitting devices 110a has a center located on a first vertex of a virtual quadrangle, so that the two first light emitting devices 110a have two centers located on two first vertexes of the virtual quadrangle. The two first vertexes are located on a diagonal line of the virtual quadrangle. The second light emitting device 110b is separated from the first light emitting device 110a, and the second light emitting device 110b has a center located on a second vertex of the virtual quadrangle. A third light emitting device 110c is separated from the first light emitting devices 110a and the second light emitting device 110b, respectively. The third light emitting device 110c has a center located on a third vertex of the virtual quadrilateral, and the second vertex and the third vertex are located on another diagonal line of the virtual quadrilateral. The on-status starting moments of the light emitting devices in the same pixel unit are not completely the same. By adopting the arrangement mode of the light emitting devices, one light emitting device may be applied to two adjacent different pixels, so that the light emitting device may be shared, and a higher display resolution may be realized by using a smaller number of light emitting devices.

In some embodiments, an area of the first light emitting device 110a is smaller than an area of the second light emitting device 110b, and is smaller than an area of the third light emitting device 110c. The target light emitting device is the first light emitting device 110a. As described above, when it is desired to achieve a target white balance effect, it is necessary to match the brightness of the light emitting devices of different colors. Thus, the light emitting device with a smaller area needs to be applied a larger driving current, to allow the light emitting device with the smaller area to have relatively higher brightness. The first light emitting device 110a may be the green light emitting device, the second light emitting device 110b may be the red light emitting device, and the third light emitting device 110c may be the blue light emitting device.

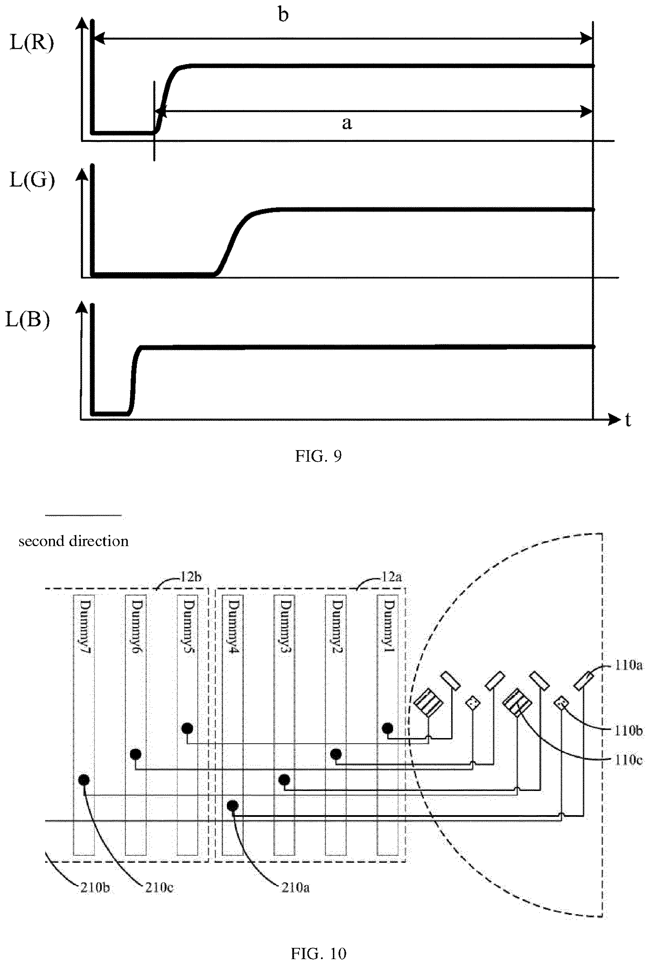

FIG. 9 is a timing schematic view illustrating on-time of a plurality of light emitting devices that have different colors in some embodiments shown in FIG. 8. An abscissa of the timing schematic view is the time, an ordinate is the brightness of the light emitting device, L (R) is the brightness of the red light emitting device, L (G) is the brightness of the green light emitting device, and L (B) is the brightness of the blue light emitting device. As illustrated FIG. 9, an on-time process may be divided into three stages, namely non-lighting stage, on-time stage, and brightness-stabilizing stage. Wherein a is a duration from the on-time stage to the brightness-stabilizing stage of the light emitting device, and b is the on-status duration of the light emitting device from the non-lighting stage to the brightness-stabilizing stage. The white image is composed of red light, green light, and blue light. Based on the pixel arrangement in the embodiment shown in FIG. 8, in order to achieve the required white light color temperature, it usually requires that the brightness of the green light emitting device is greater than the brightness of the red light emitting device, and the brightness of the red light emitting device is greater than the brightness of the blue light emitting device. Thus, the on-status duration of the green light emitting device is much longer than the on-status duration of the red light emitting device and the on-status duration of the blue light emitting device. And accordingly, the impact of the RC loading on the green light emitting device far exceeds that of the red light emitting device and the blue light emitting device, which causes the green light-emitting device to fail to achieve the target brightness in a timely manner, thereby causing purple dark fringes on the display panel. In some embodiments, by using the green light emitting device as the target light emitting device and disposing the first driving circuit corresponding to the green light emitting device in the first external sub-region, the RC loading of the green light emitting device may be effectively reduced, thereby inhibiting the purple dark fringes on the display panel and improving the color rendering quality of the display panel 10.

FIG. 10 is a schematic view illustrating a driving wire mode in some embodiments of the present disclosure. As illustrated in FIG. 10, in some embodiments, eight light emitting devices in the FIG. 10 are taken as an example for explanation. The eight light emitting devices include two second light emitting devices 110b (red), four first light emitting devices 110a (green), and two third light emitting devices 110c (blue). In some embodiments, the plurality of the driving circuits located in the same external sub-region are equidistantly disposed in the second direction with a first spacing. The light emitting devices connected to the plurality of the driving circuits located in the same external sub-region are equidistantly disposed in the second direction with a second spacing. The second spacing is positively correlated with the first spacing. In the case of occupying the same wiring region, the distances between the driving wires may be maximized by equidistant arrangement, thereby effectively inhibiting the coupling phenomenon between the driving wires, further reducing the RC loading caused by the driving wires, and improving the display quality of the display panel 10.

As illustrated in FIG. 10, the first external sub-region 12a may include a plurality of dummy pixel regions, i.e. dummy 1 to dummy 4. A preset number of driving circuits are disposed in each dummy pixel region, and the number of driving circuits in each dummy pixel region are the same. The second external sub-region 12b may also include the plurality of dummy pixel regions, i.e. dummy 5 to dummy 8. A preset number of driving circuits are disposed in each dummy pixel region, and the number of the driving circuits in each dummy pixel region are the same. The number of the dummy pixel regions in each external sub-region may correspond to the number of the light emitting devices in the external region 12. That is, each of the external sub-regions includes four dummy pixel regions, which is only for exemplary illustration, but not for limiting the protection scope of the present disclosure.

In the embodiment shown in FIG. 10, in the plurality of the light emitting devices of the same color, the length of the driving wire of the light emitting device close to the center of the transparent region 11 is greater than the length of the driving wire of the light emitting device away from the center of the transparent region 11. The term "center" may refer to the symmetry center, a mass center, a center of a diagonal line, etc. Taking the first light emitting device 110a as an example, the first driving circuit 210a corresponding to the first light emitting device 110a closest to the center of the transparent region 11 is disposed in the dummy 4 region. The first driving circuit 210a corresponding to the first light emitting device 110a farthest away from the center of the transparent region 11 is disposed in the dummy 1 region. Similarly, the second driving circuit 210b corresponding to the second light emitting device 110b closest to the center of the light transmission region 11 is disposed in the dummy 8 region, and the third driving circuit 210c corresponding to the third light emitting device 110c closest to the center of the transparent region 11 is disposed in the dummy 7 region. The total length of all required driving wires in the above manner is relatively short, and accordingly, the required area of the driving wires in the display panel 10 is also relatively small. Thus, the arrangement mode of the driving wires of the embodiments may be applied to the display panel 10 with small volume and light weight.

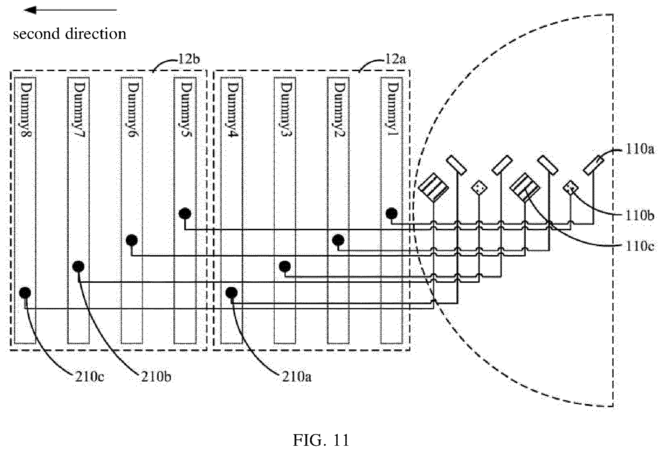

FIG. 11 is a schematic view illustrating another driving wire mode in some embodiments of the present disclosure. As illustrated in FIG. 11, the arrangement manner of the dummy pixel region is the same as that in the embodiment shown in FIG. 10, and the details are not described here again. In some embodiments, in the plurality of the light emitting devices of the same color, a difference between the lengths of the driving wires of any two of the light emitting devices is smaller than a preset threshold. That is, taking the first light emitting device 110a as an example, the first driving circuit 210a corresponding to the first light emitting device 110a closest to the center of the transparent region 11 is disposed in the dummy 1 region, and the first driving circuit 210a corresponding to the first light emitting device 110a farthest away from the center of the transparent region 11 is disposed in the dummy 4 region. Similarly, the second driving circuit 210b corresponding to the second light emitting device 110b farthest away from the center of the light transmission region 11 is disposed in the dummy 7 region, and the third driving circuit 210c corresponding to the third light emitting device 110c farthest away from the center of the transparent region 11 is disposed in the dummy 8 region. Compared with the embodiment shown in FIG. 10, the uniformity of the RC loading of each driving wire in the present embodiment is better, and accordingly, the total on-status duration of each light emitting pixel is closer to each other and the color cast problem is greatly inhibited, which facilitates subsequent gamma debugging and demura debugging.

As illustrated in FIG. 11, in some embodiments, the second driving circuit 210b of the second light emitting device 110b and the third driving circuit 210c of the third light emitting device 110c are alternately disposed at intervals. In some embodiments, the second direction may be parallel to a width direction of the display panel, and the second driving circuit 210b and the third driving circuit 210c are alternately arranged at intervals in the second direction. Based on the above connection manner, a difference of the RC loading between the second light emitting device 110b and the third light emitting device 110c may be reduced, thereby improving the matching degree of the second light emitting device 110b and the third light emitting device 110c, and further improving the color rendering quality of the display panel 10.

In some embodiments, when the number of the light emitting devices in the transparent region 11 are different, the number of the required driving wires are also different. When an aperture of the transparent region 11 is smaller, a single layer of driving wires may meet the requirement. When the aperture of the transparent region 11 is larger, two layers or three layers of driving wires, even four layers of driving wires are required, so as to avoid that the driving wires occupy too large area in the single layer.

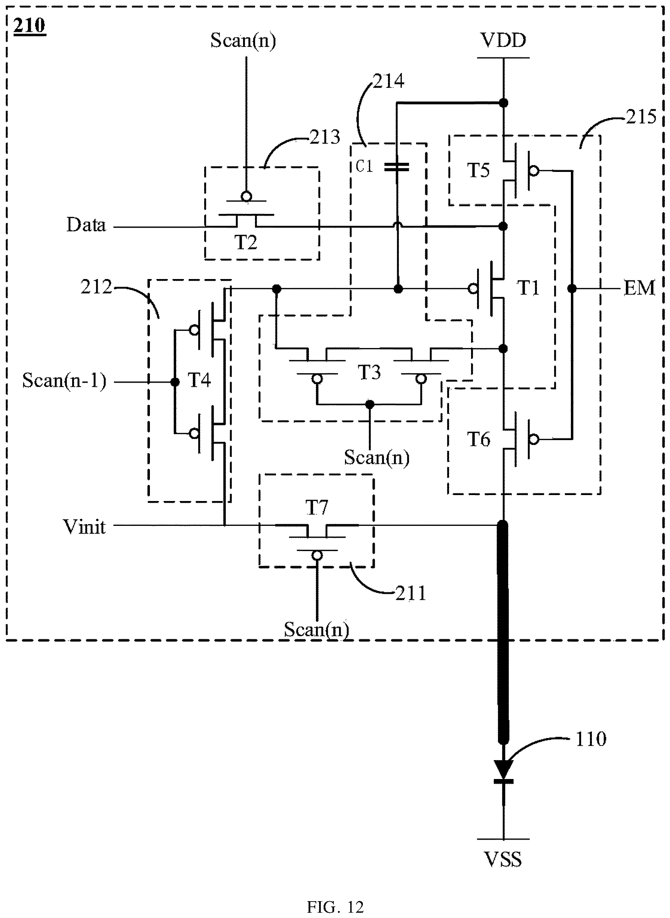

FIG. 12 is a circuit view of a driving circuit in some embodiments of the present disclosure. As illustrated in FIG. 12, in some embodiments, the driving circuit 210 includes a driving transistor T1, an anode reset unit 211, a gate electrode reset unit 212, a data writing unit 213, a threshold compensation unit 214, and a light emission control unit 215. The thickened wires in FIG. 12 are the driving wires L.

In some embodiments, the driving transistor T1 is configured to generate a driving current. The gate electrode of the driving transistor T1 is connected to the gate electrode reset unit 212. A first pole of the driving transistor T1 is configured to receive data signals that are defined as Date, and a second pole of the driving transistor T1 may output the driving current. A current value of the driving current is determined by the data signals and directly affects the light emitting brightness of the light emitting device 110.

A control terminal of the anode reset unit 211 is configured to receive second scanning signals that are defined as Smay (n), and an input terminal of the anode reset unit 211 is configured to receive reset voltage signals that are defined as Vinit. An output terminal of the anode reset unit 211 is connected to the anode of the light emitting device 110. In some embodiments, when the driving circuit 210 is the first driving circuit 210a, the output terminal of the anode reset unit 211 is connected to the anode of the first light emitting device 110a. When the driving circuit 210 is the second driving circuit 210b, the output terminal of the anode reset unit 211 is connected to the anode of the second light emitting device 110b.

The anode reset unit 211 is configured to receive the reset voltage Vinit through the input terminal after the gate electrode of the driving transistor T1 is reset, and pull down the anode of the light emitting device 110 that is connected to the anode reset unit 211 to the reset voltage Vinit, so as to reset the anode of the light emitting device 110. The reset voltage Vinit may be understood as the anode initial charging voltage of the light emitting device 110. The anode of the light emitting device 110 is reset, which allows the driving current of the light emitting device 110 to flow to the anode of the light-emitting device 110 and drive the light emitting device 110 to emit light. Further, the driving current is not affected, thereby ensuring the reliability of the light emitting brightness of the light emitting device 110.

A control terminal of the gate electrode reset unit 212 is connected to a gate electrode control terminal, and is configured to receive first scanning signals that are defined as Smay (n-1). An input terminal of the gate electrode reset unit 212 is connected to a second reset terminal, and is configured to receive the reset voltage Vinit. An output terminal of the gate electrode reset unit 212 is connected to the gate electrode of the driving transistor T1. In some embodiments, the gate electrode reset unit 212 may pull down the gate electrode voltage of the driving transistor T1 to the reset voltage Vinit according to the first scanning signals Smay (n-1) received by the control terminal, so as to reset the gate electrode of the driving transistor T1.

The data writing unit 213 includes a data writing transistor T2. A gate electrode of the data writing transistor T2 is connected to a second scanning signal Smay (n) line. A first pole of the data writing transistor T2 is connected to a data signal line, and a second pole of the data writing transistor T2 is connected to the first pole of the driving transistor T1. The data writing transistor T2 is configured to control on-off of a signal transmission path between the second scanning signal line and the first pole of the driving transistor T1 according to the second scanning signals Smay (n). In some embodiments, taking the data writing transistor T2 being a P-type transistor as an example, when the second scanning signals Smay (n) are at a low level, the data writing transistor T2 is turned on, and the data signals are transmitted to the first pole of the driving transistor T1. When the second scanning signals Smay (n) is at the low level, the data writing transistor T2 is turned off. The data writing unit 213 is not limited to the data writing transistor T2 of the embodiments, but may also be other circuit structures capable of controlling signals according to usage and realizing the function of signal transmission.

The threshold compensation unit 214 is respectively connected to the gate electrode and the second pole of the driving transistor T1, and is configured to control the on-off of the signal transmission path between the gate electrode and the second pole of the driving transistor T1 according to the second scanning signals Smay (n). By disposing the threshold compensation unit 214, the threshold voltage of the driving transistor T1 may be compensated, thereby avoiding the threshold voltage of the driving transistor T1 from affecting the brightness of the light emitting device 110.

The threshold compensation unit 214 includes a threshold compensation transistor T3 and a storage capacitance C1. The storage capacitance C1 is respectively connected to a second power voltage terminal VDD and the gate electrode of the driving transistor T1. A gate electrode of the threshold compensation transistor T3 is connected to a first scanning signal line. A first pole of the threshold compensation transistor T3 is connected to the second pole of the driving transistor T1, and a second pole of the threshold compensation transistor T3 is connected to the gate electrode of the driving transistor T1. The threshold compensation transistor T3 is configured to control the on-off of the signal transmission path between the gate electrode and the second pole of the driving transistor T1 according to the second scanning signal Smay (n). In some embodiments, taking the threshold compensation transistor T3 being the P-type transistor as an example, when the second scanning signals Smay (n) are at the low level, the threshold compensation is performed and the storage capacitor C1 is charged, so that the compensation result is stored in the storage capacitor C1.

In some embodiments, the threshold compensation transistor T3 may be a double-gate electrode transistor. By adopting the threshold compensation transistor T3 having the double-gate electrode transistor structure, the reliability of the threshold compensation may be effectively improved, thereby improving the display quality of the display device. Other transistors in the driving circuit 210 may also be the double-gate electrode transistors to further improve the display quality.

The light emitting control unit 215 includes a first control transistor T5 and a second control transistor T6. A gate electrode of the first control transistor T5 is configured to receive light emitting control signals. A first pole of the first control transistor T5 is connected to the second power supply voltage terminal, and a second pole of the first control transistor T5 is connected to the first pole of the driving transistor T1. The first control transistor T5 is configured to control the on-off of the signal transmission path between the second power supply voltage terminal and the first pole of the driving transistor T1 according to the light emitting control signals EM. A gate electrode of the second control transistor T6 is configured to receive the light emitting control signal EM. A first pole of the second control transistor T6 is connected to the second pole of the driving transistor T1, and a second pole of the second control transistor T6 is connected to the anode of the light emitting device 110. The second control transistor T6 is configured to control the on-off of the signal transmission path between the second pole of the driving transistor T1 and the anode of the light emitting device 110 according to the light emitting control signals EM. In some embodiments, taking both the first control transistor T5 and the second control transistor T6 being the P-type transistors as an example for illustration. When the light emitting control signals EM are at the low level, the first control transistor T5 and the second control transistor T6 are turned on, to pull up the voltage of the first pole of the driving transistor T1 to the second power voltage VDD. A voltage difference of the gate electrode of the first driving transistor T1 is changed, to generate and output the driving current to the light emitting device 110, thereby controlling the light emitting device 110 to emit light.

The various transistors in some embodiments are not limited to the P-type transistors, and may be N-type transistors. The type of the transistors may be different, and driving modes corresponding to the transistors may also be adaptively adjusted. The driving circuit 210 of the embodiments is not limited to the 7T1C driving circuit 210. That is, the driving circuit 210 may have another number of transistors, to achieve a lightweight display device with a smaller number of transistors, or to achieve a more flexible display function with a larger number of transistors. For example, the driving circuit 210 may be other types of driving circuits, such as 3T1C, 6T1C, or 6T2C, etc.

The embodiments of the present disclosure further provide a display device as shown in FIG. 1. The display device includes a photosensitive device 20 and the display panel 10. The photosensitive device 20 faces towards the transparent region 11 of the display panel 10. Based on the display panel 10, the display device of the present embodiment is not easy to generate display color cast, and the color rendering quality is high.

The technical features of the above embodiments may be arbitrarily combined. In order to simplify the description, all possible combinations of the technical features in the above embodiments are not described. However, as long as the combinations of the technical features do not contradict, the combinations of the technical features should be considered to be within the scope of the description.

The above embodiments only express several implementation modes of the embodiments of the present disclosure, and the descriptions thereof are more specific and detailed, but cannot be understood as limiting the scope of the disclosure. For those of ordinary skill in the art, several modifications and improvements may be made without departing from the concept of the embodiments of the present disclosure, all of which fall in the protection scope of the embodiments of the present disclosure. Thus, the protection scope of the present disclosure should be subject to the protection scope of the claims.

## Claims

1. A display panel, comprising:
a plurality of pixel units, wherein each of the pixel units comprises a plurality of light emitting devices;
a plurality of driving wires;
a plurality of driving circuits connected to the light emitting devices through the driving wires in a one-to-one correspondence manner, wherein each of the driving circuits is configured to output a driving signal to an anode of a corresponding one of the light emitting devices;
wherein a length of a corresponding driving wire of each of the light emitting devices in a same pixel unit is negatively correlated with an on-status duration of the corresponding one of the light emitting devices, and each of the driving wires is a wire connected between an output terminal of each of the driving circuits and the anode of the corresponding one of the light emitting devices.

2. The display panel as claimed in claim 1, wherein the display panel comprises a transparent region, a first external sub-region, and a second external sub-region that are arranged along a first direction; the first direction is a direction from a center of the transparent region to an outside of the transparent region; the transparent region is provided with the pixel units, and each of the pixel units comprises light emitting devices of at least two colors; and
a light emitting device with a longest on-status duration of the light emitting devices in a same pixel unit is a target light emitting device, a driving circuit corresponding to the target light emitting device is located in the first external sub-region, and driving circuits corresponding to the rest of the light emitting devices in the same pixel unit are located in the second external sub-region.

3. The display panel as claimed in claim 2, wherein the display panel comprises:
the transparent region comprising a first pixel region and a second pixel region, wherein the display panel further comprises a first external region and a second external region located at two opposite sides of the transparent region respectively;
the light emitting devices located in the first pixel region are connected to the driving circuits located in the first external region in a one-to-one correspondence manner, the light emitting devices located in the second pixel region are connected to the driving circuits located in the second external region in a one-to-one correspondence manner;
the first external region is adjacent to the first pixel region, and the second external region is adjacent to the second pixel region.

4. The display panel as claimed in claim 3, wherein the display panel comprises:
the first pixel region and the second pixel region are provided with the pixel units, each of the pixel units comprises light emitting devices of at least two colors, and the light emitting device with the longest on-status duration of the light emitting devices in the same pixel unit is the target light emitting device;
the first external region comprises the first external sub-region close to the transparent region and the second external sub-region away from the transparent region, and the second external region comprises a third external sub-region close to the transparent region and a fourth external sub-region away from the transparent region;
a driving circuit connected to the target light emitting device located in the first pixel region is located in the first external sub-region; and in the first pixel region, driving circuits connected to the rest of the light emitting devices, which are located in a same pixel unit with the target light emitting device, are located in the second external sub-region;
a driving circuit connected to the target light emitting device located in the second pixel region is located in the third external sub-region; and in the second pixel region, driving circuits connected to the rest of the light emitting devices, which are located in a same pixel unit with the target light emitting device, are located in the fourth external sub-region.

5. The display panel as claimed in claim 3, wherein a shape of the transparent region is an axisymmetric shape, and the transparent region is divided into the first pixel region and the second pixel region by a symmetry axis; the first pixel region and the first external region are sequentially disposed along a second direction, and the second pixel region and the second external region are sequentially disposed along a third direction; and the second direction and the third direction are opposite to each other and are perpendicular to the symmetry axis respectively.

6. The display panel as claimed in claim 4, wherein a shape of the transparent region is an axisymmetric shape, the first external sub-region and the third external sub-region are symmetrically disposed relative to the symmetry axis of the transparent region, and the second external sub-region and the fourth external sub-region are also symmetrically disposed relative to the symmetry axis.

7. The display panel as claimed in claim 6, wherein each of the first external sub-region, the second external sub-region, the third external sub-region, and the fourth external sub-region is rectangular.

8. The display panel as claimed in claim 7, wherein the driving circuits are disposed in the first external sub-region, the second external sub-region, the third external sub-region, and the fourth external sub-region in an array.

9. The display panel as claimed in claim 6, wherein the shape of the transparent region is circular, the first external sub-region is an annular structure surrounding the transparent region, and the second external sub-region is an annular structure surrounding the first external sub-region.

10. The display panel as claimed in any one of claims 2 to 9, wherein each of the pixel units comprises:
two first light emitting devices, wherein each of the two first light emitting devices comprises a center located on one of two first vertexes of a virtual quadrangle, and the two first vertexes are located on one diagonal line of the virtual quadrangle;
a second light emitting device separated from the first light emitting device, wherein the second light emitting device comprises a center located on a second vertex of the virtual quadrangle; and
a third light emitting device separated from the first light emitting device and the second light emitting device, wherein the third light emitting device comprises a center located on a third vertex of the virtual quadrangle, and the second vertex and the third vertex are located on another diagonal line of the virtual quadrangle;
wherein on-status starting moments of the light emitting devices in the same pixel unit are not completely the same.

11. The display panel as claimed in claim 10, wherein an area of the first light emitting device is smaller than an area of the second light emitting device, and is smaller than an area of the third light emitting device; and the target light emitting device is the first light emitting device.

12. The display panel as claimed in claim 11, wherein the first light emitting device is a green light emitting device.

13. The display panel as claimed in claim 11, wherein the second light emitting device is a red light emitting device, the third light emitting device is a blue light emitting device, and driving circuits of the red light emitting device and driving circuits of the blue light emitting device are alternately disposed at intervals.

14. The display panel as claimed in any one of claims 2 to 9, wherein the driving circuits located in a same external sub-region are equidistantly disposed with a first spacing, the light emitting devices connected to the driving circuits located in a same external sub-region are equidistantly disposed with a second spacing, and the second spacing is positively correlated with the first spacing.

15. The display panel as claimed in any one of claims 2 to 9, wherein the first external sub-region comprises a plurality of dummy pixel regions, and the second external sub-region comprises a plurality of dummy pixel regions, a preset number of driving circuits are respectively disposed in each of the dummy pixel regions, and a number of the driving circuits in each of the dummy pixel regions are the same.

16. The display panel as claimed in any one of claims 2 to 9, wherein in light emitting devices of the same color, a length of the driving wire of the light emitting device close to the transparent region is greater than a length of the driving wire of the light emitting device away from the transparent region.

17. The display panel as claimed in any one of claims 2 to 9, wherein in light emitting devices of the same color, a difference between lengths of driving wires of any two of the light emitting devices is less than a preset threshold value.

18. The display panel as claimed in any one of claims 1 to 9, wherein each of the driving wires is an indium tin oxide metal wire or an aluminum zinc oxide metal wire.

19. A display device, comprising:
a photosensitive device; and
the display panel as claimed in any one of claims 1 to 18, wherein the photosensitive device faces towards the transparent region of the display panel.

20. The display device as claimed in claim 19, wherein the photosensitive device is a camera.
